## Europäisches Patentamt

## European Patent Office

## Office européen des brevets

(19)

(11) Publication number: **0 216 070**
B1

(12)

# EUROPEAN PATENT SPECIFICATION

(45) Date of publication of the patent specification:
07.03.90

(51) Int. Cl.⁴: **G01V 3/08**, G01V 3/15, G01R 33/06

(21) Application number: 86110250.7

(22) Date of filing: 25.07.86

(54) Instrument for sensing ferromagnetic bodies.

(30) Priority: 25.07.85 CA 487454

(43) Date of publication of application:
01.04.87 Bulletin 87/14

(45) Publication of the grant of the patent:
07.03.90 Bulletin 90/10

(84) Designated Contracting States:
AT BE CH DE FR GB IT LI LU NL SE

(56) References cited:
EP-A- 0 096 380
EP-A- 0 143 378
CH-A- 649 849
DE-A- 1 623 110
DE-A- 2 551 968
DE-A- 3 117 021
GB-A- 2 130 730
GB-A- 2 135 460
GB-A- 2 140 568
US-A- 4 066 962

(73) Proprietor: Numec Instruments Inc., 150 Ferrier Street Unit 2, Markham Ontario L3R 3K3(CA)

(72) Inventor: Gee, George, 75 Rooksnest Trail, Scarborough Ontario MIS 3W4(CA)
Inventor: Alexander, George, 8 Ravenshoe Road, Queensville Ontario LOG 1RO(CA)

(74) Representative: Patentanwälte Dr. Solf & Zapf, Zeppelinstrasse 53, D-8000 München 80(DE)

## Description

### FIELD OF THE INVENTION:

The present invention relates to a portable magnetic flux sensing instrument according to the precharacterizing part of claim 1, having particular application as a magnetometer for locating buried ferro-magnetic metallic bodies.

### BACKGROUND OF THE INVENTION:

There are many different types of flux sensing instruments, including magnetometer-type devices, which are used to locate buried bodies. These bodies generate a magnetic flux and/or distort the magnetic field of the earth, which is sensed by the flux sensing instrument.

Flux sensing instruments have particular application for use in the construction industry where it is important to locate underground bodies such as water supply valve stems, and the like. A number of portable flux sensing instruments are presently available, designed for this particular application, but often lacking in required sensitivity.

A flux sensing instrument according to the precharacterizing part of claim 1 is known from EP-A2-0 096 380. This publication describes a magnetometer, comprising two magnetic flux probes, i.e. Hall elements, arranged spaced from one another in tube members. The Hall elements, however, are connected in a bridge circuit in such a manner, that the magnetic field of the earth is compensated and a detection of an inhomogeneity of this magnetic field, through which the Hall elements induce different voltages, causes an unbalance in the bridge circuit, so that a voltage appears in the bridge branch. This voltage is then amplified and indicated optically or acoustically.

### SUMMARY OF THE PRESENT INVENTION:

The present invention provides a magnetic flux sensing instrument, which has been particularly designed to improve the use and take advantage of the sensitivity of Hall effect devices.

More particularly, the present invention provides a magnetic flux sensing instrument for locating bodies causing a distorting flux by generating a magnetic flux and/or distorting the earth's magnetic field. The instrument comprises first and second Hall effect devices, each of which generates an electrical signal, proportional to the level of any such distorting flux to which each Hall device is exposed. The two Hall effect devices being spaced from one another, so that, when approaching a body, the first device is positioned for different exposure to such distorting flux and therefore generates an electrical signal, different from that of the second device.

For offsetting effects of the earth's magnetic field on the instrument, first and second field bucking means are provided in accordance with the present invention, which are controlled by processing means, receiving the electrical signals to induce first and second bucking fields for opposing the distorting flux at the first and second Hall effect devices respectively. The processing means in turn provides first and second flux related signals, representative of the levels of bucking required at each of the first and second Hall effect devices. These signals are received by means for comparing magnitudes of the first and second flux related signals and having output means for showing differences therebetween, indicating the presence of the body.

As described above, the field bucking means has a two-fold function, one of which is to cancel the effects of the earth's magnetic field on the instrument and the other of which is to oppose the distorting flux at each of the first and second Hall effect devices.

### BRIEF DISCUSSION OF THE DRAWINGS:

The above, as well as other advantages and features of the present invention will be described in greater details, according to the preferred embodiments of the present invention in which:

Figure 1 is a perspective view showing the use of a magnetic flux sensing instrument, according to a preferred embodiment of the present invention;

Figure 2 is a side plan view of the sensing instrument of Figure 1;

Figure 3 is an enlarged longitudinal sectional view of the lower end of the instrument of Figure 1 when in a retracted, storage position;

Figure 4 is a side plan view of the lower end of the instrument of Figure 1 when in the extended use position and showing; in phantom, the separated sensor arrangements, according to a preferred embodiment of the present invention;

Figure 5 is an enlarged, exploded, perspective view of the mounting arrangements of the Hall effect device, of Figure 3;

Figure 6 is a further exploded perspective view showing the mounting of the Hall effect device, as well as the field bucking member of the arrangement of Figure 3;

Figure 7 is an enlarged, perspective view of the end of the arrangement from Figure 6, when assembled;

Figure 8 is an enlarged, sectional view of the hand-held housing portion of the instrument of Figure 1;

Figure 9 is an enlarged, perspective view of the display and control end of the housing portion of Figure 8;

Figure 10 is a schematic, block diagram, of an electrical circuit used for the operation of the instrument of Figures 1 through 9, according to a preferred embodiment of the present invention.

### DETAILED DESCRIPTION ACCORDING TO THE PREFERRED EMBODIMENTS OF THE PRESENT INVENTION:

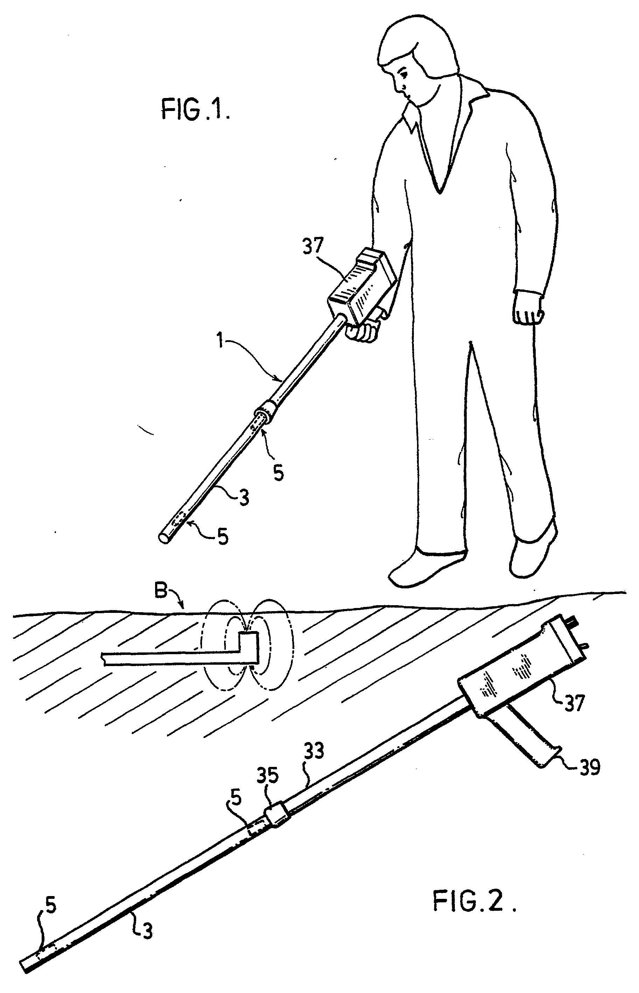

In Figure 1, a magnetic flux sensing instrument 1, is used for locating a body or anomaly B, buried beneath ground level and causing an anomalous flux, as shown in the drawing. The instrument senses the body's magnetic field to indicate the presence of the body.

The instrument itself includes a housing section 37, having a handle 39, for holding the instrument, as shown in Figure 1. Extending outwardly from the housing portion is a first elongated probe-like body portion 3, telescopically engaged with a second, slightly larger diameter body section 33. In the Figures 1 and 2 arrangement, these two body sections are shown in an extended use position where they are secured by means of a threaded nut 35; however, by releasing the nut, body section 3 can be telescoped interiorly of body section 33 to provide compact storage of the instrument.

The sensing instrument includes a pair of magnetic field sensing assemblies 5, provided in the probe-like body section 3 and spaced apart from one another, as shown in Figures 1 and 2. This arrangement provides a gradient or differential-type sensing, in that in the Figure 1 arrangement the first lower sensor assembly is much more heavily exposed to the flux from the body, than is the second upper assembly. From a very broad standpoint the operation of the instrument results from this type of gradient sensing.

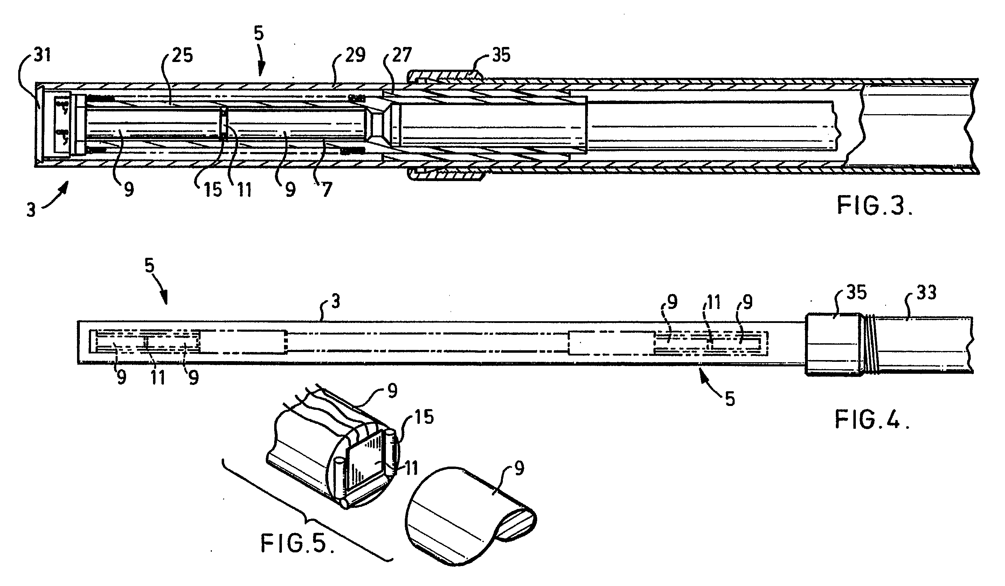

Gradient sensing, in itself, is not new; however, unique to the present invention is the specific sensing arrangement, as shown in Figures 3 through 10 of the drawings.

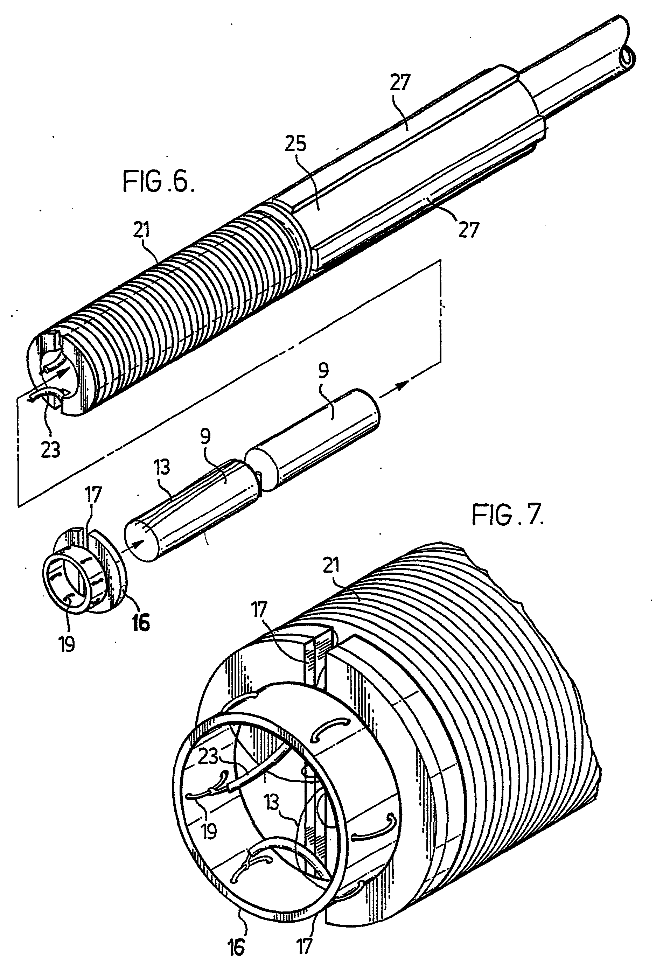

More specifically, each of the first and second sensor assemblies includes a Hall effect device 11, as best shown in Figure 5. The Hall effect device is positioned between two ferrite core pieces 9, and attached to one end of one of the core pieces. Provided outwardly around the Hall effect device is a raised border 15, which blocks the other core piece from abutting and damaging the Hall effect device. The two core pieces and the Hall effect device are positioned internally of an enlarged hollow region 7 within an elongated non-magnetic inner support portion 25, covered externally by an outer casing 29, of extendable body or probe portion 3, of the sensing instrument.

Wrapped externally around the support portion 25, directly over the Hall effect device and core pieces is a continuous coil of wire, 21, of substantially the same length as the two core pieces when placed end to end, internally of the helical coil, as shown in Figure 6.

Each of the hollow regions in the probe portion is open at its outer end for fitting of the core pieces in position and of reduced diameter at its inner end, to act as an end stop for locating the core pieces in position. After the core pieces Hall effect devices and coil have been assembled, as shown in Figure 6, a capping member 16 is then fitted onto the support portion, to trap the sensor assembly in its assembled position. The capping member 16 includes open slotted region 17, and a plurality of preset wires 19, for receiving the electrical wiring 13 and 23 from the Hall effect device and the covering coil, respectively. From here the sensor assembly is wired back to the control housing.

Once the inner support 25 of the probe has been assembled, it is inserted within casing 3 protected on one end by means of a permanent end cap 31. Provided around the inner support portion 25 are a plurality of foam strips 27, which act as a shock absorber between the inner support and the outer casing portions of probe 3.

It is to be appreciated that each of the sensor assemblies is, as shown in Figure 4, set up in an identical manner, with the Hall effect devices being separated from one another by a spacing of about 20 to 21 inches (1 inch = 25,4 mm). This distance provides effective separation of the two sensor assemblies, for purposes of carrying out the sensing according to the present invention, while at the same time providing strength to the support portion, to maintain the core pieces in alignment with one another and enabling the coils to cancel the effects of the earth's magnetic field on the instrument, as is known in the art.

The actual operation of the Hall effect tranducer assemblies is, as follows:

As the instrument approaches an anomaly, causing a distortion in the earth's magnetic field, each of the Hall effect devices produces an electrical signal which is proportional to its excitation current, and the axial component of the magnetic flux it experiences. However, the first lower Hall effect device will produce a greater electrical signal than the second upper Hall effect device, because of its increased exposure to the magnetic field generated by body B.

The electrical signals from the two Hall effect devices are fed back to the control region 55 of housing 37 and processed to produce a voltage to drive the two field bucking coils 21, associated with the first and second Hall effect devices. Each of these coils generates a magnetic flux, equal in amplitude, but opposite in polarity, to the magnetic flux sensed at the first and second Hall effect devices.

The two drive voltages required at the first and second field bucking coils are then compared. If there is a difference in the amplitude of the two drive voltages at the first and second field bucking coils this indicates the presence of the body.

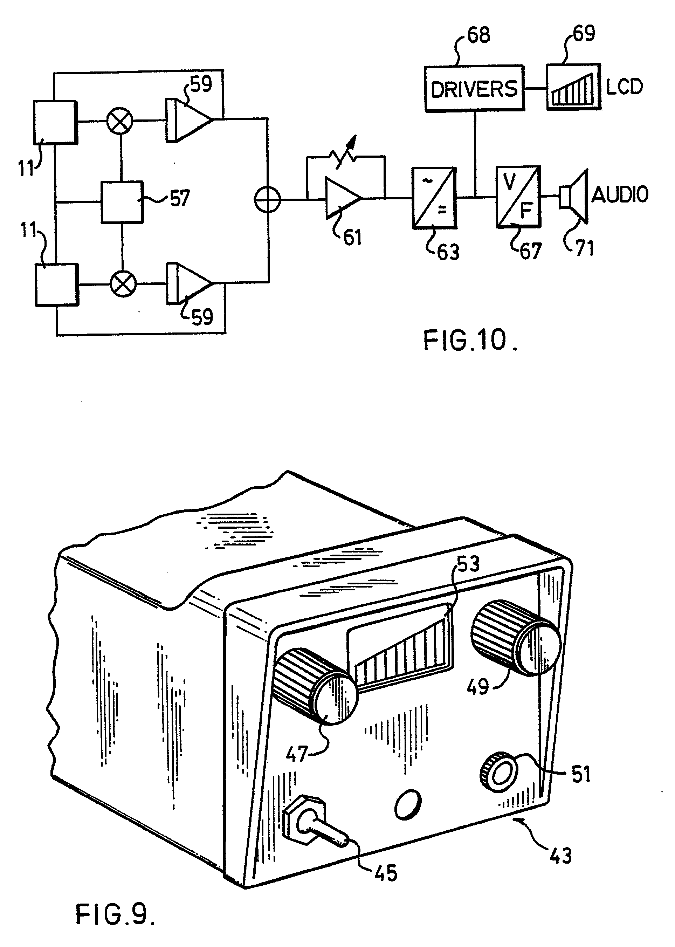

Figure 10 shows a specific electrical circuit which is used to operate the instrument, as described above. In this particular circuit, each of the Hall effect devices 11, is excited by a driver oscillator 57. The outputs from the two Hall effect devices are processed by a pair of synchronous integrators 59, which produce the drive for the two field bucking coils. The drive voltages from the synchronous integrators provide flux-related signals, which are in opposite electrical polarity for the first and second field bucking coils. These two flux-related signals, are then added in a variable gain summing amplifier 61, having a zero output provided that both sensors are experiencing the same flux. However, a gradient or difference in the flux levels at the two Hall effect devices, results in an output signal from the amplifier which is increased either positively or negatively by the amplifier, depending upon the gradient. This output signal is then rectified in a precision rectifier 63, to a voltage to frequency convertor 67, which then "sees" a positive voltage and produces an increase in frequency at its output. This frequency is heard through an audio annunciator 71, audible to the operator's ear. In addition, the output from the rectifier is visually displayed through a liquid crystal display 69 driven by LCD drivers 68.

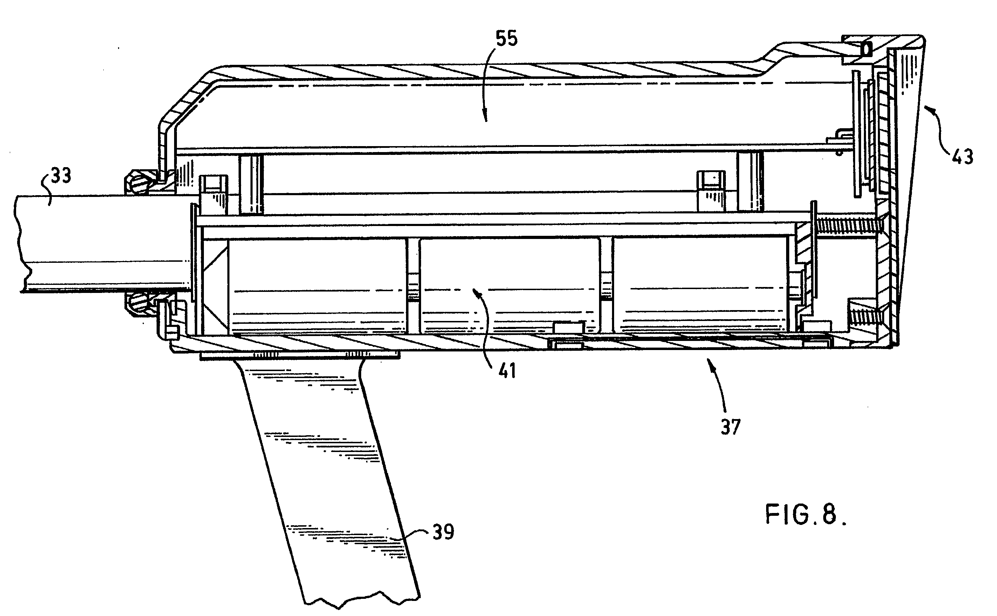

Figures 8 and 9 show preferred features of the control housing for the unit. The display and control region 43 includes a switch 45, controlling the on/off operation of batteries 41. These batteries provide power to the Figure 10 circuit, to operate the instrument. Controls 47 and 49 are provided to respectively adjust sensitivity of the circuit the output of which is visually displayed at display region 53 and volume as audibly displayed through an electrostatic audio transducer, or from an earpiece of similar design through a headset, connected to the circuit through panel jack 51. In the visual mode, a bargraph will move across the display region, while in the audio mode the presence of the body will be indicated by a change in frequencies heard from the instrument.

Although various preferred embodiments of the present invention have been described herein in detail, it will be appreciated by those skilled in the art, that variations may be made thereto without departing from the scope of the invention as claimed.

## Claims

1. A magnetic flux sensing instrument (1) for locating bodies (B), generating an own magnetic flux and/or causing a distortion of the earth's magnetic field, comprising first and second Hall effect devices (11), each of which generates an electrical signal proportionate to the level of any distorting flux caused by a body (B) as a distortion of the earth's magnetic field, when each Hall effect device (11) is exposed to the distorting flux, said Hall effect devices (11) are spaced from one another on said instrument (1) such that, when approaching a body (B), said first Hall effect device (11) is positioned for different exposure to such distorting flux and generates an electrical signal different from said second Hall effect device (11), characterized by first and second field bucking means (21) for offsetting effects of the earth's magnetic field on said instrument (1) and controlled by processing means (59) receiving the electrical signals of said Hall effect devices (11) to induce first and second bucking fields for bucking the distorting flux at said first and second Hall effect devices (11), respectively, said processing means (59) in turn providing first and second flux related signals representative of the level of bucking required at each of said first and second Hall effect devices (11), means (61) for comparing magnitudes of said first and second flux related signals and having output means (69, 71) for showing differences therebetween indicating presence of a body (B) causing a distortion of the earth's magnetic field.

2. An instrument, as claimed in Claim 1, characterized in that said instrument (1) includes a first non-magnetic elongated straight centrally hollowed body member (3) comprising an inner support (25) and an outer casing portion (29), said inner support portion (25) having first and second spaced apart co-axially aligned enlarged hollow regions (7) in which said first and second Hall effect devices (11) are located, and said first and second field bucking means comprising first and second helical coils (21) wrapped outwardly around each of said first and second enlarged hollow regions (7) and covered by said outer casing portion (29).

3. An instrument, as claimed in Claim 2, characterized in that axially aligned core pieces (9) are provided in said first and second hollow regions (7) for directing flux between said coils (21).

4. An instrument, as claimed in Claim 3, characterized in that each of said first and second Hall effect devices (11) is trapped by a pair of ferrite core pieces (9) within its respective enlarged hollow region (7), one of the ferrite core pieces (9) within each pair having a projection means (15) bordering and preventing damage to the Hall effect device (11) between the core pieces (9).

5. An instrument, as claimed in one or more of claims 2 to 4, characterized in that shock absorbing means (27) is provided between said inner support (25) and said outer casing portions (29) of said first body member (3).

6. An instrument, as claimed in one or more of claims 2 to 5, characterized in that end cap members (16) are provided at each of said enlarged hollow regions (7), both said Hall effect devices (11) and said coils (21) being wired to said end cap members (16) which are in turn electrically connected to controls for said instrument including said processing and signal comparison means (59, 61).

7. An instrument, as claimed in one or more of claims 2 to 6, characterized in that a handle control portion (39) and a second elongated hollow body member (33) extending from said handle control portion (39) are provided with said first body member (3) being telescopically supported by said second body member (33) with locking means (35) for locking said first body member (3) in either one of an extended sensing and a retracted storage position relative to said second body member (33).

8. An instrument, as claimed in one of more of claims 2 to 7, characterized in that means (61) are provided for amplifying and highlighting differences between said first and second flux related signals.

9. An instrument, as claimed in Claim 8, including a control housing (43) for said processing means, characterized in that said processing means comprises a synchronous integrator (59) providing opposing drive voltages for said first and second helical coils (21) and a variable gain amplifier (61) for adding said opposing drive voltages and for amplifying differences therebetween.

10. An instrument, as claimed in Claim 9, characterized by a rectifier (63) for providing a positive voltage output from said variable gain amplifier (61).

11. An instrument, as claimed in Claim 9 or 10, characterized by a liquid crystal display (69) for visually displaying the output from said amplifier (61).

12. An instrument, as claimed in one or more of Claims 9 to 11, characterized by a voltage to frequency convertor (67) and audio means (71) for audibly indicating output from said converter (67) and said amplifier (61), respectively.

**Patentansprüche**

1. Magnetflußerfassendes Instrument (1) für das Lokalisieren von Körpern (B), die einen eigenen Magnetfluß erzeugen und/oder die eine Störung des Erdmagnetfeldes verursachen, umfassend erste und zweite Halleffekt-Vorrichtungen (11), wobei jede davon ein elektrisches Signal erzeugt, das proportional der Stärke von irgendeinem Störfluß, verursacht durch einen Körper (B), als Störung des Erdmagnetfeldes ist, wenn jede der Halleffekt-Vorrichtungen (11) dem Störfluß ausgesetzt wird, wobei die besagten Halleffekt-Vorrichtungen (11) voneinander im Abstand in besagtem Instrument (1) derart angeordnet sind, daß bei einer Annäherung an einen Körper (B) die besagte erste Halleffekt-Vorrichtung dem Störfluß unterschiedlich ausgesetzt angeordnet ist, und ein elektrisches Signal erzeugt, das unterschiedlich ist von demjenigen der zweiten Halleffekt-Vorrichtung (11), gekennzeichnet durch
   - erste und zweite Feldkompensationsmittel (21) für das Ausgleichen der Wirkung des Erdmagnetfeldes auf das besagte Instrument (1) und die durch Bearbeitungsmittel (59) gesteuert werden, welche die elektrischen Signale der besagten Halleffekt-Vorrichtungen (11) aufnehmen, um erste und zweite Kompensationsfelder für das Ausgleichen des Störflusses entsprechend an den besagten ersten und zweiten Halleffekt-Vorrichtungen (11) zu induzieren, wobei die Bearbeitungsmittel (59) nacheinander erste und zweite flußbezogene Signale erzeugen, die repräsentativ für die Stärke der Kompensationen sind, die an jeder der beiden Halleffekt-Vorrichtungen (11) erforderlich sind,
   - Mittel (61) für das Vergleichen der Größenordnung der besagten ersten und zweiten flußbezogenen Signale, und
   - Ausgabemittel (69, 71) für die Darstellung von Unterschieden zwischen den Signalen für die Anzeige des Vorhandenseins eines Körpers (B), der eine Störung des Erdmagnetfeldes erzeugt.
2. Instrument nach Anspruch 1, dadurch gekennzeichnet, daß das besagte Instrument (1) ein erstes nichtmagnetisches längsausgedehntes, zentrales, hohlförmig ausgebildetes Körperteil (3) umfaßt, mit einer inneren Halterung (25) und einer äußeren Gehäusepartie (29), wobei besagte innere Halterungspartie (25) erste und zweite voneinander koaxial in Abstand in Linie angeordnete längsausgedehnte, hohlförmige Partien (7) umfaßt, in welchen die besagten ersten und zweiten Halleffekt-Vorrichtungen (11) angeordnet sind, und wobei die besagten ersten und zweiten Feldkompensationsmittel erste und zweite spiralförmige Wicklungen (21) umfassen, die um jede der beiden besagten längsausgedehnten, hohlförmigen Partien (7) außen herum gewickelt sind und durch die besagte äußere Gehäusepartie (29) überdeckt sind.
3. Instrument nach Anspruch 2, dadurch gekennzeichnet, daß axial ausgerichtete Kernstücke (9) in besagten ersten und zweiten hohlförmigen Partien (7) angeordnet sind, für das Leiten des Flusses zwischen den besagten Wicklungen (21).

4. Instrument nach Anspruch 3, dadurch gekennzeichnet, daß jede der beiden besagten ersten und zweiten Halleffekt-Vorrichtungen (11) durch ein Paar von Ferritkernstücken (9) innerhalb seiner entsprechenden, längsausgedehnten, hohlförmigen Partie (7) eingeschlossen sind, wobei eines der Ferritkernstücke (9) innerhalb jedes Paares vorstehende Mittel (15) umfaßt, die die Halleffekt-Vorrichtung (11) seitlich begrenzen und diese zwischen den Kernstücken (9) vor Beschädigung schützen.

5. Instrument nach einem oder mehrerer der Ansprüche 2 bis 4, dadurch gekennzeichnet, daß erschütterungsabsorbierende Mittel (27) zwischen besagter innerer Halterung (25) und besagter äußerer Gehäusepartie (29) von besagtem ersten Körperteil (3) vorgesehen sind.

6. Instrument nach einem oder mehrerer der Ansprüche 2 bis 5, dadurch gekennzeichnet, daß Endabdeckteile (16) an jeder der besagten längsausgedehnten, hohlförmigen Partie (7) vorgesehen sind, wobei sowohl die besagte Halleffekt-Vorrichtung (11) als auch die besagten Wicklungen (21) an die besagten Endabdeckteile (16) angeschlossen sind, die der Reihe nach elektrisch mit Steuerungen für das besagte Instrument verbunden sind, die die besagten bearbeitungs- und signalvergleichenden Mittel (59, 61) umfassen.

7. Instrument nach einem oder mehrerer der Ansprüche 2 bis 6, dadurch gekennzeichnet, daß eine Handgriff-Steuerpartie (39) und ein zweites, längsausgedehntes, hohlförmiges Körperteil (33), das sich von der besagten Handgriffssteuerpartie (39) aus erstreckt, zusammen mit besagtem ersten Körperteil (3) vorgesehen sind, das durch das besagte zweite Körperteil (33) teleskopartig gehalten wird, mit Arretiermittel (35) für das Arretieren des besagten ersten Körperteils (3) entweder in einer ausgezogenen Meß- oder in einer zurückgezogenen Aufbewahrungs-Position, relativ zu besagtem zweiten Körperteil (33).

8. Instrument nach einem oder mehrerer der Ansprüche 2 bis 7, dadurch gekennzeichnet, daß Mittel (61) für das Verstärken und Anzeigen von Unterschieden zwischen den besagten ersten und zweiten flußbezogenen Signalen vorgesehen sind.

9. Instrument nach Anspruch 8, umfassend ein Steuerungsgehäuse (43) für die besagten Bearbeitungsmittel, dadurch gekennzeichnet, daß die Bearbeitungsmittel einen synchronen Integrator (59) umfassen, der entgegengesetzte Betriebsspannungen für die besagten ersten und zweiten spiralförmigen Wicklungen (21) erzeugt und ein variabler Vorverstärker (61) für das Aufaddieren der besagten entgegengesetzten Betriebsspannungen und für die Verstärkung von Differenzen zwischen diesen Spannungen.

10. Instrument nach Anspruch 9, dadurch gekennzeichnet, daß ein Rektifizierer (63) für das Erzeugen eines positiven Spannungsausgabesignales von besagtem variablem Vorverstärker (61) vorgesehen ist.

11. Instrument nach einem der Ansprüche 9 oder 10, dadurch gekennzeichnet, daß eine Flüssigkristallanzeige (69) für die visuelle Anzeige des Ausgabesignales von besagtem Verstärker (61) angeordnet ist.

12. Instrument nach einem der Ansprüche 9 bis 11, gekennzeichnet durch eine Spannung an einem Frequenzkonverter (67) und Audiomittel (71) für die hörbare Ausgabesignalangabe von besagtem Konverter (67) und entsprechend von besagtem Verstärker (61).

## Revendications

1.- Instrument (1) pour la détection de corps ferromagnétiques, pour localiser des corps (B) engendrant un flux propre et/ou provoquant une distorsion du flux magnétique terrestre, comprenant un premier et un second dispositif à effet Hall (11) engendrant chacun un signal électrique proportionnel au niveau de tout flux causant une distorsion, provoqué par un corps (B), tel qu'une distorsion du champ magnétique terrestre, quand chaque dispositif à effet Hall (11) est exposé au flux causant la distorsion, lesdits dispositifs à effet Hall (11) étant espacés l'un de l'autre sur ledit instrument (1) de telle sorte que, à l'approche d'un corps (B), ledit premier dispositif à effet 5 Hall (11) est positionné pour une exposition différente audit flux causant la distorsion, et engendre un signal électrique différent, de l'exposition et du signal du second dispositif à effet Hall (11), caractérisé par un premier et un second moyen (21) de tarage de champ, pour les effets décalés du champ magnétique terrestre sur le dit instrument (1), et commandés par des moyens de traitement (59) recevant les signaux électriques desdits dispositifs à effet Hall (11) pour induire le premier et le second champ de tarage et tarer le flux causant la distorsion, respectivement audit premier et audit second dispositif à effet Hall (11), lesdits moyens de traitement (59) fournissant à leur tour des signaux relatifs au premier et au second flux, représentatifs du niveau de tarage requis à chacun, desdits premier et second dispositifs à effet Hall (11), ainsi que par des moyens (61) pour comparer les grandeurs desdits signaux relatifs au premier et au second flux et ayant des moyens de sortie (69, 71) pour montrer les différences entre eux indiquant la présence d'un corps (B) provoquant une distorsion du champ magnétique terrestre.

2.- Instrument tel que revendiqué à la revendication 1 caractérisé en ce que ledit instrument (1) inclut un premier organe rectiligne allongé non magnétique (3) en forme de corps creux en son centre, comprenant un support interne ) (25) et une partie de protection externe (29), ledit support interne (25) présentant une première et une seconde zone à trou élargi, coaxialement alignées et espacées l'une de l'autre, dans lesquelles sont logés ledit premier et ledit second dispositif à effet Hall (11) et lesdits premier et 5 second moyen de tarage de champ comprenant des premier et second enroulements hélicoïdaux (21) enveloppant chacun extérieurement chacun desdites première et seconde zones à trous élargis (7) et recouvert par ladite partie de protection externe (29).

3.- Instrument tel que revendiqué à la revendication 2, caractérisé en ce que des pièces en forme de noyaux axialement alignées (9) sont prévues dans lesdites première et seconde zones creuses (7) pour diriger le flux entre lesdites bobines (21).

4.- Instrument tel que revendiqué à la revendication 3, caractérisé en ce que chacun desdits premier et second dispositifs à effet Hall (11) est piégé par une paire de pièces au forme de noyaux de ferrite (9) dans la zone à trou élargi respective (7), une des pièces en forme de noyau de ferrite (9) de chaque paire, ayant un moyen saillant (15) limitant et évitant tout dommage au dispositif à effet Hall (11) entre les pièces en forme de noyaux (9).

5.- Instrument tel que décrit selon une des revendications 2 à 4 ou plus, caractérisé en ce que des moyens amortisseurs de chocs (27) sont prévus entre ledit support interne (25) et lesdites parties externes de protection (29) dudit premier organe en forme de corps (3).

6.- Instrument tel que revendiqué selon une des revendications, 2 à 5 ou plus, caractérisé en ce que des organes de fermeture extrême (16) sont prévus dans chacune des zones à trou élargi (7), lesdits dispositifs à effet Hall (11) et lesdits enroulements (21) étant reliés auxdits organes terminaux de fermeture (16) qui à leur tour sont reliés électriquement à des commandes pour ledit instrument comprenant lesdits moyens de traitement et de comparaison de signaux (59, 61).

7.- Instrument tel que revendiqué selon une des revendications 2 à 6 ou plus, caractérisé en ce qu'une partie de commande à poignée (39) et un second organe allongé en forme de corps creux (33) s'étendant depuis ladite partie de commande à poignée (39), sont prévus avec ledit premier organe (3) en forme de corps monté télescopiquement sur ledit second organe en forme de corps (33) par des moyens de verrouillage (35) pour verrouiller ledit premier organe en forme de corps (3) dans l'une quelconque des positions, l'une étendue de détection, l'autre rétractée d'enregistrement, par rapport audit second organe (33) en forme de corps.

8.- Instrument tel que revendiqué selon l'une des revendications 2 à 7 ou plus, caractérisé en ce que des moyens (61) sont prévus pour amplifier et accontuer les différences entre les signaux relatifs audit premier et audit second flux.

9.- Instrument tel que revendiqué à la revendication 8 comprenant un boîtier de commande (43) pour lesdits moyens de traitement, caractérisé en ce que lesdits moyens de traitement comprennent un intégrateur synchrone (59) fournissant des tensions d'alimentation opposées audit premier et audit second enroulement (21) et un amplificateur à gain variable (61) pour ajouter lesdites tensions d'alimentation opposées et pour amplifier les différences entre elles.

10.- Instrument tel que revendiqué à la revendication 9, caractérisé par un redresseur (63) fournissant une sortie de tension positive audit amplificateur à gain variable (61).

11.- Instrument tel que revendiqué à la revendication 9 ou 10 caractérisé par un affichage à cristaux liquides (69) pour afficher visuellement la sortie dudit amplificateur (61).

12.- Instrument tel que revendiqué à l'une des revendications 9 à 11 ou plus caractérisé par un convertisseur tension/fréquence (67) et des moyens audio (71) pour indiquer respectivement de façon audible la sortie dudit convertisseur (67) et dudit amplificateur (61).

FIG.1.

37

1

5

3

5

B

33

35

5

37

39

5

5

3

FIG.2.

FIG.3.

FIG.4.

FIG.5.

EP 0 216 070 B1

FIG.6.

FIG.7.

FIG.8.

EP 0 216 070 B1

FIG.10.

FIG.9.